# EUROPÄISCHE PATENTSCHRIFT

(11) **EP 0 825 638 B1**
(45) Veröffentlichungstag und Bekanntmachung des Hinweises auf die Patenterteilung: **04.10.2001**
(21) Anmeldenummer: 97110326.2
(22) Anmeldetag: 24.06.1997
(51) Int. Cl.: H01L 21/205, H01L 21/033, H01L 21/308, H01L 21/311, H01L 21/3205

(54) **Verfahren zur Herstellung feiner Strukturen**
Method of manufacturing fine structures
Procédé de fabrication de structures fines

(30) Priorität: 14.08.1996 DE 19632834
(43) Veröffentlichungstag der Anmeldung: 25.02.1998
(73) Patentinhaber: Infineon Technologies AG, 81669 München (DE)
(72) Erfinder: Schäfer, Herbert, 85635 Höhenkirchen-Siegertsbrunn (DE); Franosch, Martin, 81739 München (DE); Stengl, Reinhard, 86391 Stadtbergen (DE); Lehmann, Volker, 80689 München (DE); Reisinger, Hans, 82031 Grünwald (DE); Wendt, Hermann, 85630 Grasbrunn (DE)
(74) Vertreter: Zedlitz, Peter, Dipl.-Inf.

(56) Entgegenhaltungen:
- EP-A- 0 567 748
- EP-A- 0 655 788
- US-A- 5 158 905
- US-A- 5 254 503
- US-A- 5 346 846
- MINE T ET AL: "CAPACITANCE-ENHANCED STACKED-CAPACITOR WITH ENGRAVED STORAGE ELECTRODE FOR DEEP SUBMICRON DRAMS" JAPANESE JOURNAL OF APPLIED PHYSICS, SUPPLEMENTS, 28.August 1989, Seiten 137-140, XP000607864
- SANDIP TIWARI ET AL: "VOLATILE AND NON-VOLATILE MEMORIES IN SILICON WITH NANO-CRYSTAL STORAGE" TECHNICAL DIGEST OF THE INTERNATIONAL ELECTRON DEVICES MEETING (IEDM), WASHINGTON, DEC. 10 - 13, 1995, 10.Dezember 1995, INSTITUTE OF ELECTRICAL AND ELECTRONIC ENGINEERS, Seiten 521-524, XP000624761
- PATENT ABSTRACTS OF JAPAN vol. 017, no. 295 (E-1377), 7.Juni 1993 & JP 05 021798 A (ALPS ELECTRIC CO LTD), 29.Januar 1993,

## Beschreibung

In der Halbleitertechnologie ist für verschiedene Anwendungen die Herstellung feiner Strukturen erforderlich.

Im Hinblick auf die zunehmende Miniaturisierung werden in der Halbleitertechnologie Masken mit immer feineren Strukturen benötigt. Die Masken werden als Ätzmasken oder Implantationsmasken verwendet.

Ferner ist vielfach die Herstellung feiner Strukturen erforderlich, die in dem herzustellenden Bauelement oder der herzustellenden Anordnung als aktiver oder passiver Bestandteil verbleiben. Das gilt sowohl für mikroelektronische Bauelemente bzw. Anordnungen als auch für mikromechanische Bauelemente bzw. Anordnungen.

Ein derartiges Bauelement, das als flüchtiger und nicht flüchtiger Speicher geeignet ist, ist z. B. in S. Tiwari et al, IEDM 95, S. 521-524 vorgeschlagen worden. Das Bauelement umfaßt als Speicherzelle einen MOS-Transistor, in dessen Gatedielektrikum sogenannte Silizium-Nano-Kristalle als Ladungsspeicher vorgesehen sind. Es handelt sich dabei um kleine Siliziumkristalle mit Durchmessern von 5 nm, die in einer Matrix aus SiO₂ eingebettet sind. In diesen Siliziumkristallen wird Ladung gespeichert, die ähnlich der gespeicherten Ladung auf einem Floating-Gate eines EEPROMs die Einsatzspannung des MOS-Transistors beeinflußt. Unterhalb der Siliziumkristalle angeordnetes SiO₂ wirkt dabei als Tunneloxid. Die Siliziumkristalle werden durch spontane Zersetzung und Vereinigung von Material bei CVD-Abscheidungen gebildet. Größe und Packungsdichte der entstehenden Siliziumkristalle sind dabei schwer zu kontrollieren.

Der Erfindung liegt daher das Problem zugrunde, ein Verfahren zur Herstellung feiner Strukturen anzugeben, bei der die Pakkungsdichte der feinen Strukturen besser einstellbar ist. Darüber hinaus soll die Größe der feinen Strukturen einstellbar sein.

Dieses Problem wird erfindungsgemäß gelöst durch ein Verfahren gemäß Anspruch 1. Weitere Ausgestaltungen der Erfindung gehen aus den übrigen Ansprüchen hervor.

Zur Herstellung feiner Strukturen werden auf der Oberfläche eines Substrats in einem CVD-Verfahren unter Verwendung eines ersten Prozeßgases, das in einem Trägergas SiH₄ und GeH₄ enthält, Keime gebildet, die die Abmessungen der feinen Strukturen bestimmen. Derartige Keime werden auch als Nanokristalle bezeichnet. Die Keime entstehen statistisch verteilt ohne Einsatz von lithographischen Verfahren. Daher sind geringere Strukturgrößen erzielbar, als es der Auflösung der Lithographie entspricht.

Dabei wird die Erkenntnis ausgenutzt, daß die Zugabe von GeH₄ bei einer CVD-Abscheidung unter Verwendung eines Prozeßgases, das hauptsächlich SiH₄ in einem Trägergas, z. B. H₂, enthält, die Keimbildung von Siliziumkeimen verzögert. Über die Zugabe von GeH₄ kann daher die Keimdichte eingestellt werden. Weiterhin wurde festgestellt, daß bei Verwendung von H₂ als Trägergas die Keimbildung zusätzlich unterdrückt wird. Die Keimbildung erfolgt vorzugsweise bei-Temperaturen zwischen 500°C und 700°C.

Die Keimbildung wird unterbrochen, sobald eine vorgegebene Dichte der Keime erreicht ist. Die Größe der Keime wird anschließend durch selektive Epitaxie von Silizium eingestellt. Dazu wird ein zweites Prozeßgas verwendet, das SiH₂Cl₂ in einem Trägergas, zum Beispiel H₂, enthält.Die selektive Epitaxie erfolgt im Temperaturbereich zwischen 600°C und 800°C. Dieser Gasmischung kann darüber hinaus GeH₄ zugegeben werden, um die Materialzusammensetzung der Keime und damit Materialeigenschaften wie z. B. Ätzselektivitäten, Austrittsarbeit und ähnliches einzustellen.

Vorzugsweise werden die Keime mit Strukturgrößen im Bereich zwischen 1 und 100 nm gebildet. Das heißt, die Durchmesser der Keime liegen im Bereich zwischen 1 und 100 nm und die Abstände zwischen benachbarten statistisch verteilten Maskenstrukturen liegen ebenfalls in diesem Größenbereich. Damit werden Packungsdichten im Bereich zwischen 10⁸ und 10¹³ pro cm² erreicht.

Dabei liegt es im Rahmen der Erfindung, daß das Substrat eine Maskenschicht umfaßt. Auf deren Oberfläche werden die Keime gebildet. Durch anisotropes Ätzen unter Verwendung der Keime als Ätzmaske wird aus der Maskenschicht anschließend eine Maske gebildet. Die Maske kann sowohl als Ätzmaske als auch als Implantationsmaske oder ähnliches verwendet werden. Sie weist Strukturen in der Größe der Keime auf.

Ferner liegt es im Rahmen der Erfindung, auf das Substrat eine erste dielektrische Schicht aufzubringen, auf deren Oberfläche die Keime gebildet werden. Darauf wird eine zweite dielektrische Schicht und eine leitfähige Schicht aufgebracht. Die leitfähige Schicht, die erste dielektrische Schicht und die zweite dielektrische Schicht werden strukturiert. Dabei werden eine Gateelektrode und ein Gatedielektrikum eines MOS-Transistors gebildet. In dem Gatedielektrikum bilden die zwischen der ersten dielektrischen Schicht und der zweiten dielektrischen Schicht angeordneten Keime Ladungsspeicher. Im Substrat werden ein Source-Gebiet und ein Drain-Gebiet für den MOS-Transistor gebildet.

Vorzugsweise werden dabei die Keime aus Silizium/Germanium gebildet. Über dem Germaniumanteil in den Keimen ist die Austrittsarbeit einstellbar. Damit ist ein Workfunction-Engineering möglich.

Als Substrat ist z. B. ein Halbleitersubstrat, vorzugsweise aus monokristallinem Silizium oder ein SOI-Substrat geeignet, dessen Oberfläche mit einer isolierenden Schicht versehen ist.

Im folgenden wird die Erfindung anhand von Ausführungsbeispielen, die in den Figuren dargestellt sind, näher erläutert. Die Darstellung in den Figuren sind nicht maßstäblich.
- Figur 1: zeigt ein Substrat mit einer zu strukturierenden Schicht und einer Maskenschicht nach der Bildung von Keimen auf der Oberfläche der Maskenschicht.
- Figur 2: zeigt das Substrat nach Strukturierung der Maskenschicht. unter Verwendung der Keime als Ätzmaske.
- Figur 3: zeigt das Substrat nach Verwendung der strukturierten Maskenschicht als Ätzmaske bei der Strukturierung der zu strukturierenden Schicht.
- Figur 4: zeigt ein Substrat mit Feldoxidbereichen, einer ersten dielektrischen Schicht und auf der Oberfläche der ersten dielektrischen Schicht gebildeten Keimen.
- Figur 5: zeigt das Substrat nach Aufbringen einer zweiten dielektrischen Schicht und einer leitfähigen Schicht.
- Figur 6: zeigt das Substrat nach Bildung einer Gateelektrode und eines Gatedielektrikums sowie von Source- und Drain-Gebieten.

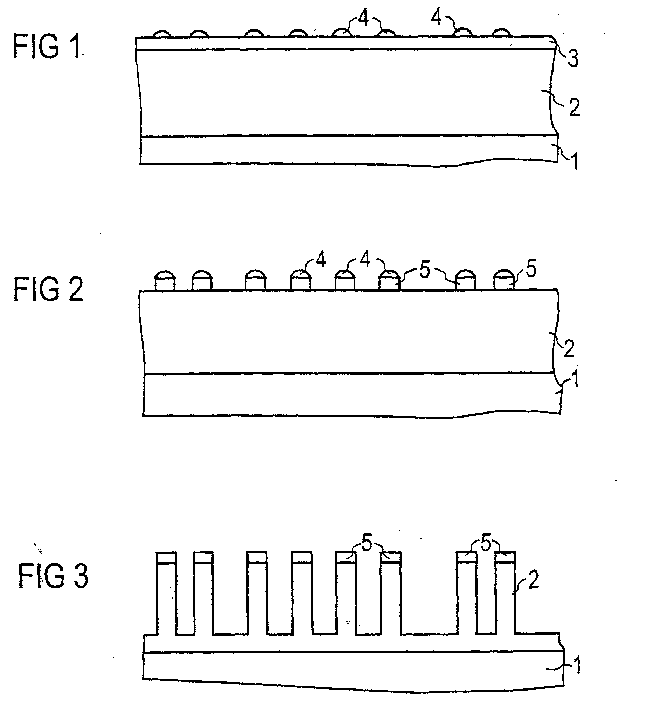

Auf einem Substrat 1 aus z. B. monokristallinem Silizium ist eine zu strukturierende Schicht 2 aus z. B. Polysilizium, epitaktisch aufgewachsenem Silizium, Metall, Metallsilizid, SiO₂, Si₃N₄ oder ähnlichem angeordnet. Darauf ist eine Maskenschicht 3 angeordnet aus einem Material, das als Ätzmaske bei der Strukturierung der zu strukturierenden Schicht 2 geeignet ist. Besteht die zu strukturierende Schicht 2 aus Silizium, so ist für die Maskenschicht 3 z. B. SiO₂ geeignet (s. Figur 1).

Auf der Oberfläche der Maskenschicht 3 werden statistisch verteilte Keime 4 während einer Gasphasenabscheidung in einer Epitaxieanlage gebildet. Als Prozeßgas wird eine Atmosphäre aus H₂ und SiH₄ verwendet, wobei H₂ das Trägergas bildet. Ferner umfaßt die Atmosphäre GeH₄, das zur Verzögerung des Keimbildungsprozesses zugegeben wird. Der Partialdruck von SiH₄ und GeH₄ liegt im Bereich von 10⁻³ bis 1 hPa, der Partialdruck von H₂ liegt im Bereich von 1 bis 100 hPa. Die Abscheidung wird im Temperaturbereich zwischen 500°C und 700°C durchgeführt. Bei diesen Prozeßbedingungen bilden sich an der Oberfläche der Maskenschicht 3 einzelne Keime 4 aus Silizium. Sobald die Dichte der Keime 4 eine vorgegebene Dichte von etwa 10¹⁰/cm² erreicht hat, wird der Keimbildungsprozeß abgebrochen.

Anschließend werden die Prozeßbedingungen verändert, um die Größe der Keime 4 gezielt einzustellen. Dazu werden Prozeßbedingungen eingestellt, wie sie für die selektive Epitaxie benutzt werden. Bei diesen Prozeßbedingungen ist eine weitere Keimbildung an der Oberfläche der Maskenschicht 3 unterbunden. Die selektive Epitaxie erfolgt z. B. mit einer Gasmischung aus H₂ und SiH₂Cl₂ im Temperaturbereich zwischen 600°C und 800°C. Dieser Gasmischung kann darüber hinaus GeH₄ zugegeben werden, um die Materialzusammensetzung der Keime 4 und damit Materialeigenschaften wie z. B. Ätzselektivitäten und ähnliches einzustellen.

Sobald der Durchmesser der Keime 4 einem vorgegebenen Wert entspricht, wird der Abscheideprozeß abgebrochen. Die Keime 4 bilden eine statistische Maske.

In einem anisotropen Ätzprozeß, der die Maskenschicht 3 selektiv zu den Keimen 4 angreift, wird die Maskenschicht 3 strukturiert. Aus der Maskenschicht 3 wird dabei eine Maske 5 gebildet (s. Figur 2).

Anschließend wird ein anisotroper Ätzprozeß durchgeführt, der Silizium selektiv zu SiO₂ angreift. Dabei wird die zu strukturierende Schicht 2 strukturiert (s. Figur 3). Gleichzeitig werden die Keime 4, die aus Silizium oder Siliziumgermanium bestehen, entfernt. Der anisotrope Ätzprozeß wird z. B. mit HBr durchgeführt.

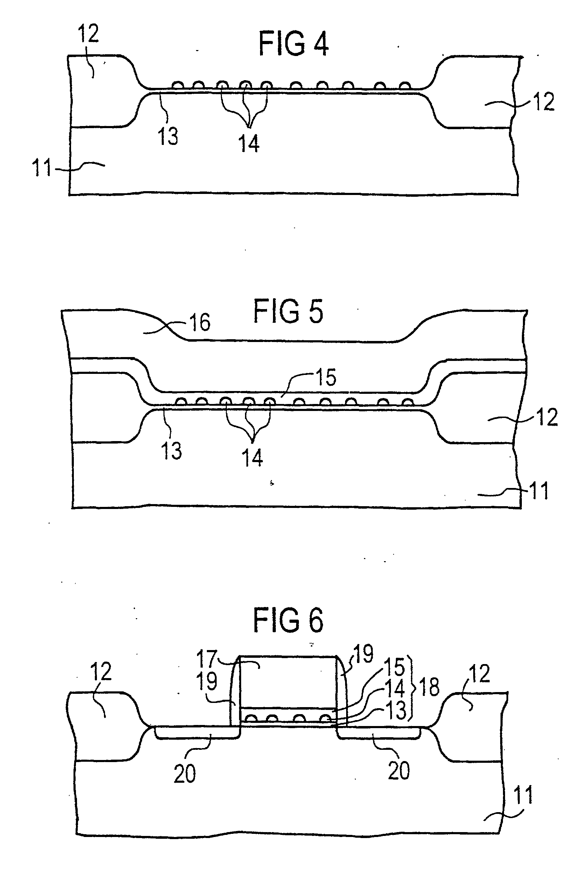

In einem Substrat 11 aus z. B. monokristallinem Silizium werden Feldoxidbereiche 12 gebildet, die ein aktives Gebiet für einen MOS-Transistor definieren (s. Figur 4). Die Feldoxidbereiche 12 werden z. B. in einem Locos-Prozeß gebildet.

Innerhalb der Feldoxidbereiche 12 wird eine erste dielektrische Schicht 13 aus z. B. SiO₂ in einer Schichtdicke von z. B. 3 nm gebildet.

Auf der Oberfläche der der ersten dielektrischen Schicht 13 werden statistisch verteilte Keime 14 während einer Gasphasenabscheidung in einer Epitaxieanlage gebildet. Als Prozeßgas wird eine Atmosphäre aus H₂ und SiH₄. verwendet, wobei H₂ das Trägergas bildet. Ferner umfaßt die Atmosphäre GeH₄, das zur Verzögerung des Keimbildungsprozesses zugegeben wird. Der Partialdruck von SiH₄ GeH₄ liegt im Bereich von 10⁻³ bis 1 hPa, der Partialdruck von H₂ liegt im Bereich von 1 bis 100 hPa. Die Abscheidung wird im Temperaturbereich zwischen 500°C und 700°C durchgeführt. Bei diesen Prozeßbedingungen bilden sich an der Oberfläche der ersten dielektrischen Schicht 13 einzelne Keime 14 aus Silizium. Sobald die Dichte der Keime 14 eine vorgegebene Dichte von etwa 10⁸/cm² erreicht hat, wird der Keimbildungsprozeß abgebrochen.

Anschließend werden die Prozeßbedingungen verändert, um die Größe der Keime 14 gezielt einzustellen. Dazu werden Prozeßbedingungen eingestellt, wie sie für die selektive Epitaxie benutzt werden. Bei diesen Prozeßbedingungen ist eine weitere Keimbildung an der Oberfläche der ersten dielektrischen Schicht 13 unterbunden. Die selektive Epitaxie erfolgt z. B. mit einer Gasmischung aus H₂ und SiH₂Cl₂ im Temperaturbereich zwischen 600°C und 800°C. Dieser Gasmischung wird darüber hinaus GeH₄ zugegeben werden, um die Materialzusammensetzung der Keime 4 und damit die Austrittsenergie einzustellen.

Sobald der Durchmesser der Keime 14 einem vorgegebenen Wert entspricht, wird der Abscheideprozeß abgebrochen. Die Keime werden mit einem Durchmesser von zum Beispiel 5 nm und einer Flächendichte von zum Beispiel 10¹² cm⁻² gebildet. Die Keime 14 bilden in dem MOS-Transistor Ladungsspeicher.

Es wird ganzflächig eine zweite dielektrische Schicht 15 aus z. B. SiO₂ in einer Schichtdicke von z. B. 3 nm abgeschieden (s. Figur 5). Darauf wird eine leitfähige Schicht 16 aus z. B. n-dotiertem Polysilizium aufgebracht. Die leitfähige Schicht 16 wird in einer Dicke von z. B. 150 nm gebildet.

Anschließend werden unter Verwendung fotolithographischer Prozeßschritte die leitfähige Schicht 16, die zweite dielektrische Schicht 15 und die erste dielektrische Schicht 13 strukturiert. Dabei werden eine Gateelektrode 17 und ein Gatedielektrikum 18 gebildet (s. Figur 6). Das Gatedielektrikum 18 umfaßt die strukturierte erste dielektrische Schicht 13 und die strukturierte zweite dielektrische Schicht 15 sowie die dazwischen angeordneten Keime 14. Außerhalb des Gatedielektrikums 18 angeordnete Keime 14 werden bei der Strukturierung ebenfalls entfernt.

Durch Abscheiden einer SiO₂-Schicht mit im wesentlichen konformer Kantenbedeckung und anisotropes Rückätzen werden an den Flanken von Gateelektrode 17 und Gatedielektrikum 18 Spacer 19 aus SiO₂ gebildet.

Abschließend wird durch Implantation z. B. von Phosphor oder Arsen selbstjustiert zur Gateelektrode 17 und zu den Feldoxidbereichen 12 Source-/Drain-Gebiete 20 gebildet.

Je nach Dicke der ersten dielektrischen Schicht 13 ist der MOS-Transistor als flüchtiger oder nicht flüchtiger Speicher geeignet. Die Information wird dabei in Form von in den Keimen 14 eingefangener Ladung gespeichert.

## Patentansprüche

1. Verfahren zur Herstellung feiner Strukturen,
- bei dem auf der Oberfläche eines Substrats (1, 2, 3) in einem CVD-Verfahren unter Verwendung eines ersteh Prozeßgases, das in einem Trägergas SiH₄ und GeH₄ enthält, Keime (4) gebildet werden, die die Abmessungen der feinen Strukturen bestimmen,
- bei dem das CVD-Verfahren unter Verwendung des ersten Prozeßgases unterbrochen wird, sobald die Keime (4) eine vorgegebene Dichte erreicht haben,
- bei dem durch selektive Epitaxie unter Verwendung eines zweiten Prozeßgases, das SiCl₂H₂ und/oder GeH₄ in einem Trägergas enthält, die Größe der Keime (4) eingestellt wird.

2. Verfahren nach Anspruch 1,
bei dem das erste Prozeßgas als Trägergas H₂, N₂, Ar, oder He enthält.

3. Verfahren nach Anspruch 1 oder 2,
bei dem die Keime (4) mittlere Durchmesser und mittlere Abstände jeweils im Bereich zwischen 1 und 100 nm aufweisen.

4. Verfahren nach einem der Ansprüche 1 bis 3,
- bei dem das Substrat eine Maskenschicht (3) umfaßt, auf deren Oberfläche die Keime (4) gebildet werden,
- bei dem durch anisotropes Ätzen unter Verwendung der Keime als Ätzmaske aus der Maskenschicht (3) eine Maske (5) gebildet wird.

5. Verfahren nach einem der Ansprüche 1 bis 3,
- bei dem auf das Substrat (11) eine erste dielektrische Schicht (13) aufgebracht wird, auf deren Oberfläche die Keime (14) gebildet werden,
- bei dem eine zweite dielektrische Schicht (15) und eine leitfähige Schicht (16) aufgebracht werden,
- bei dem die leitfähige Schicht (16) und die erste dielektrische Schicht (13) und die zweite dielektrische Schicht (15) strukturiert werden zur Bildung einer Gateelektrode (17) und eines Gatedielektrikums (18) eines MOS-Transistors, in dem die zwischen der ersten dielektrischen Schicht (13) und der zweiten dielektrischen Schicht (15) angeordneten Keime (14) Ladungsspeicher bilden,
- bei dem im Substrat (11) ein Source-Gebiet und ein Drain-Gebiet (20) für den MOS-Transistor gebildet werden.

## Claims

1. Method for fabricating fine structures,
- in which nuclei (4) are formed on the surface of a substrate (1, 2, 3) in a CVD method using a first process gas containing SiH₄ and GeH₄ in a carrier gas, the said nuclei determining the dimensions of the fine structures,
- in which the CVD method using the first process gas is interrupted as soon as the nuclei (4) have reached a predetermined density,
- in which the size of the nuclei (4) is set by selective epitaxy using a second process gas containing SiCl₂H₂ and/or GeH₄ in a carrier gas.

2. Method according to Claim 1,
in which the first process gas contains, as carrier gas H₂, N₂, Ar, or He.

3. Method according to Claim 1 or 2,
in which the nuclei (4) have average diameters and average spacings in each case in the range between 1 and 100 nm.

4. Method according to one of Claims 1 to 3,
- in which the substrate comprises a mask layer (3), on the surface of which the nuclei (4) are formed,
- in which a mask (5) is formed from the mask layer (3) by anisotropic etching using the nuclei as etching mask.

5. Method according to one of Claims 1 to 3,
- in which a first dielectric layer (13) is applied to the substrate (11), the nuclei (14) being formed on the surface of the said dielectric layer,
- in which a second dielectric layer (15) and a conductive layer (16) are applied,
- in which the conductive layer (16) and the first dielectric layer (13) and the second dielectric layer (15) are patterned in order to form a gate electrode (17) and. a gate dielectric (18) of a MOS transistor in which the nuclei (14) arranged between the first dielectric layer (13) and the second dielectric layer (15) form charge stores,
- in which a source region and a drain region (20) for the MOS transistor are formed in the substrate (11).

## Revendications

1. Procédé de fabrication de structures fines,
- dans lequel on forme à la surface d'un substrat (1, 2, 3), dans un procédé de dépôt en phase vapeur, en utilisant un premier gaz de processus qui contient SiH₄ et GeH₄ dans un gaz porteur, des germes (4) qui déterminent les dimensions des structures fines,
- dans lequel on interrompt le procédé de dépôt en phase vapeur avec utilisation du premier gaz de processus dès que les germes (4) on atteint une densité prescrite,
- dans lequel on règle par épitaxie sélective, en utilisant un deuxième gaz de processus, qui contient SiCl₂H₂ et/ou GeH₄ dans un gaz porteur, la dimension des germes (2).

2. Procédé suivant la revendication 1, dans lequel le premier gaz de processus contient comme gaz porteur H₂, N₂, Ar ou He.

3. Procédé suivant la revendication 1 ou 2, dans lequel les germes (4) ont des diamètres moyens et des distances moyennes les unes aux autres chaque fois dans l'intervalle compris entre 1 et 100 nm.

4. Procédé suivant l'une des revendications 1 à 3,
- dans lequel le substrat forme une couche (3) de masque à la surface de laquelle on forme les germes (4),
- dans lequel on forme par attaque chimique anisotrope, en utilisant les germes comme d'attaque chimique, un masque (5) à partir de la couche (3) de masque.

5. Procédé suivant l'une des revendications 1 à 3,
- dans lequel on dépose sur le substrat (11) une première couche (13) diélectrique à la surface de laquelle on forme les germes (14),
- dans lequel on dépose une deuxième couche (15) diélectrique et une couche (16) conductrice,
- dans lequel on structure la couche (16) conductrice et la première couche (13) diélectrique et la deuxième couche (15) diélectrique pour former une électrode (17) de grille et un diélectrique (18) de grille d'un transistor MOS dans lequel les germes (14) disposés entre la première couche (13) diélectrique et la deuxième couche (15) diélectrique forment des accumulateurs de charge,
- dans lequel on forme dans le substrat (11) une région de source et une région (20) de drain pour le transistor MOS.
